(19) Europäisches Patentamt
European Patent Office
Office européen des brevets

(11) **EP 2 650 985 B1**

(12) **EUROPÄISCHE PATENTSCHRIFT**

(45) Veröffentlichungstag und Bekanntmachung des Hinweises auf die Patenterteilung:
**15.03.2017 Patentblatt 2017/11**

(51) Int Cl.:
*H01S 5/04* *(2006.01)*     *H01S 5/028* *(2006.01)*
*H01S 5/12* *(2006.01)*     *H01S 3/094* *(2006.01)*
*H01L 33/06* *(2010.01)*

(21) Anmeldenummer: **13162600.4**

(22) Anmeldetag: **05.04.2013**

(54) **System zur Frequenzkonversion sowie Halbleiterbauelement**

System for frequency conversion and semiconductor component

Système de conversion de fréquence ainsi qu'élément semi-conducteur

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.04.2012 DE 102012205834**

(43) Veröffentlichungstag der Anmeldung:
**16.10.2013 Patentblatt 2013/42**

(73) Patentinhaber: **Forschungsverbund Berlin e.V. 12489 Berlin (DE)**

(72) Erfinder:
• **Weyers, Markus**
  **15745 Wildau (DE)**
• **Erbert, Götz**
  **02708 Löbau (DE)**

(74) Vertreter: **Gulde & Partner**
**Patent- und Rechtsanwaltskanzlei mbB**
**Wallstraße 58/59**
**10179 Berlin (DE)**

(56) Entgegenhaltungen:
EP-A1- 0 666 623     DE-A1- 10 312 742
US-A1- 2004 066 823     US-A1- 2010 202 487

• H.K. TSANG ET AL: "First demonstration of two photon absorption in a semiconductor waveguide pumped by a diode laser", ELECTRONICS LETTERS, Bd. 29, Nr. 18, 2. September 1993 (1993-09-02), Seite 1660, XP055071697, ISSN: 0013-5194, DOI: 10.1049/el:19931105
• AITCHISON J S ET AL: "ROLE OF TWO-PHOTON ABSORPTION IN ULTRAFAST SEMICONDUCTOR OPTICAL SWITCHING DEVICES", APPLIED PHYSICS LETTERS, AIP, AMERICAN INSTITUTE OF PHYSICS, MELVILLE, NY, US, Bd. 56, Nr. 14, 2. April 1990 (1990-04-02) , Seiten 1305-1307, XP000149807, ISSN: 0003-6951, DOI: 10.1063/1.102502
• C. MORO ET AL: "Stimulated emission induced by two-photon absorption in GaAs quantum wells", PHYSICAL REVIEW B, Bd. 44, Nr. 15, 15. Oktober 1991 (1991-10-15), Seiten 8384-8386, XP055071609, ISSN: 0163-1829, DOI: 10.1103/PhysRevB.44.8384

EP 2 650 985 B1

**Beschreibung**

*Beschreibung*

*Stand der Technik*

Die vorliegende Erfindung betrifft ein System zur Frequenzkonversion.

Bekannte Halbleiterlaserdioden umfassen einen hochdotierten pn-Übergang und erzeugen Photonen, indem primäre Photonen Elektron-Loch-Paare zur strahlenden Rekombination stimulieren. Die primären Photonen werden durch die dabei erzeugten Photonen verstärkt, wobei die Wellen der einzelnen Photonen in Phase sind, d.h. es entsteht ein kohärenter Wellenzug. Für den Betrieb eines Halbleiterlasers müssen bekanntermaßen mehr Elektronen und Löcher bereitgestellt werden, als sie im Gleichgewichtszustand vorhanden sind. Dieser Zustand wird auch als Besetzungsinversion bezeichnet. Zur Erzeugung von Laserstrahlung durchlaufen die Photonen in einem Resonator geführt mehrfach einen Bereich in dem Besetzungsinversion vorliegt. Dieser Bereich wird auch aktive Zone genannt und liegt typischerweise zwischen p- und n-Halbleiter.

Bekannte Halbleiter-Laserdioden im Wellenlängenbereich von etwa 390 nm bis 480 nm bestehen üblicherweise aus Galliumnitrid GaN. GaN ist allgemein ein III-V-Halbleiter, der aufgrund seiner Atome Gallium aus der chemischen Hauptgruppe III und Stickstoff aus der chemischen Hauptgruppe V im Allgemeinen eine vergleichsweise große elektronische Bandlücke von 3,37 eV aufweist. Die mittels einer Halbleiterlaserdiode erzeugbare Wellenlängen λ von Laserstrahlung entspricht bekanntermaßen in etwa

$$\lambda = c \cdot \frac{h}{E_{gap}}$$

wobei c die Lichtgeschwindigkeit, h das plancksche Wirkungsquantum und $E_{gap}$ die Energie der Bandlücke des Halbleiters ist.

Bekannte langwellige GaN-basierte Laserdioden emittieren bei ca. 530 nm, kurzwellige bei ca. 350 nm. In beiden Fällen sind die Kenndaten der Laserdioden jedoch noch unausgereift. Auch bei den im Prinzip kommerziell erhältlichen Wellenlängen im Bereich von 400 nm bis 480 nm schränken technologische Begrenzungen, wie etwa ein durch geringe p-Leitfähigkeit dominanter Serienwiderstand, das Design der Wellenleiterstruktur und damit die Strahlqualität ein.

Viele Wellenlängen können auf herkömmliche Weise nicht durch Halbleiterlaserdioden direkt erschlossen werden, sondern werden beispielsweise durch Frequenzverdopplung einer primären Laserstrahlungsquelle mittels entsprechender Kristalle erzeugt. Zur Erhöhung der Effizienz sind das in der Regel Kristalle mit Quasi-Phasenanpassung, z.B. periodisch gepoltes Lithiumniobat. Eine derartige periodische Polung kann auch in GaN-basierten Strukturen durch die Kombination von metallpolaren und N-polaren Bereichen, die mit Zweischrittepitaxie lateral nebeneinander angeordnet werden, erreicht werden. Die US 2004/0061074 beschreibt eine solche GaN-basierte Struktur.

DE 103 12 742 A1 offenbart einen vertikal emittierenden Laser, der eine Absorberschicht zur Zwei-Photonen-Absorption aufweist. Zwar weist ein solcher vertikal emittierender Laser den Vorteil auf, dass die Strahlform der emittierten Laserstrahlung durch einen externen Resonator festgelegt wird, jedoch erlaubt die Anordnung gemäß Fig. 4 der DE 103 12 742 A1 lediglich die Extraktion der Laserstrahlung nach oben über den Durchmesser des durch einen externen Resonator vorgegebenen Strahls, der kleiner als die Länge des Bauelements sein muss. Die Extraktion der Strahlung nach oben steht dazu noch in Konkurrenz zur nicht nutzbaren Emission über die Facetten 45 und 46.

US 2004/0066823 A1 offenbart eine Laserstruktur, die sowohl elektrisch gepumpt wird und somit optische (Pump-)Strahlung erzeugt als auch eine nichtlineare optische Schicht aufweist, die ebenfalls innerhalb des Resonators angeordnet ist und eine Frequenzkonversion des Pump-Strahlung ohne Verwendung optischer Koppler realisiert. Somit befinden sich sowohl die Pumpquelle als auch die aktive Schicht innerhalb einer gemeinsamen Kavität. Da es derzeit keine Halbleiterheterostrukturen für Diodenlaser gibt, die bei etwa der halbe Emissionswellenlänge noch ausreichend transparent sind bzw. nicht absorbieren, kann die Lösung der US 2004/0066823 A1 lediglich für (unipolare Kaskaden-) Laser verwendet werden, die bei sehr langen Wellenlängen emittieren. Somit ist die Laserstruktur der US 2004/0066823 A1 für die Generation von Laserstrahlung im schwer zugänglichen kurzwelligen Bereich jedoch nicht geeignet. Weiterhin nachteilhaft ist es, dass die Pumplaserdiode und das frequenzkonvertierende Bauteil aufgrund ihrer monolithischen Integration innerhalb einer gemeinsamen Kavität nicht ausreichend individuell optimiert werden können.

US 5,341,390 A offenbart eine vertikal emittierende, zur Frequenzverdopplung ausgebildete Vorrichtung, die sowohl elektrisch gepumpt wird und somit Laserstrahlung erzeugt als auch eine nichtlineare optische Schicht aufweist, die innerhalb des Resonators angeordnet ist und eine Frequenzkonversion des Laserlichts ohne Verwendung optischer Koppler realisiert, wobei der Frequenzkonversionsprozess auf der Symmetrie eines Zinkblendegitters beruht. Eine direkte Übertragung auf GaN-basierte Strukturen, die ein Wurtzitgitter aufweisen, ist daher nicht möglich. Nachteilhafterweise basiert dieses Bauelement weiterhin auf der Erzeugung der zweiten Harmonischen und nicht auf einer Mehrphotonenabsorption und davon unabhängiger anschließender strahlender Rekombination in einem Quantengraben. Darüber hinaus ist das in der US 5,341,390 A offenbarte Bauelement aufgrund der Vielzahl der verwendeten Schichten komplex und kostenintensiv.

H.K. Tsang et al.: "First demonstration oft wo photon absorption in a semiconductor waveguide pumped by a diode laser", Electronics Letters, Bd. 29, Nr. 18, S 1660 offenbart ein Experiment, bei dem eine Zwei-Photonenabsorption in einem Wellenleiter aus einem halbleitenden Material erfolgt, wobei der Wellenleiter durch einen Diodenlaser optisch gepumpt wird.

DE 103 12 742 A1 offenbart einen vertikal emittierenden Laser, der eine Absorberschicht zur Zwei-Photonen-Absorption (Frequenzverdopplung) aufweist.

### Offenbarung der Erfindung

Aufgabe der Erfindungen ist es daher, Laserstrahlung in einem größeren Wellenlängenbereich erzeugen zu können, sowie höhere Flexibilität beim Design von Wellenleitern und damit der Strahlform eines Lasers zu erreichen. Außerdem ist es Aufgabe der Erfindung Probleme der Dotierung, insbesondere der p-Dotierung in breitlückigen Halbleitern zu umgehen, die bisher zu Beschränkungen in der Dicke von Wellenleiterschichten durch den damit verbundenen elektrischen Widerstand führten.

Erfindungsgemäß wird diese Aufgabe durch den Gegenstand in Anspruch 1 gelöst.

Das erfindungsgemäße System zur Frequenzkonversion umfasst ein kantenemittierendes Halbleiterbauelement und eine davon beabstandete Pumplaserdiode, die optische Pumpstrahlung einer ersten Wellenlänge erzeugt, wobei das kantenemittierende Halbleiterbauelement eine Halbleitersubstratschicht und auf der Halbleitersubstratschicht epitaktisch aufgewachsene Halbleiterschichten, die eine aktive Zone und eine Wellenleiterschicht umfassen, aufweist, wobei eine Eintrittsfacette und eine Austrittsfacette seitlich der aktiven Zone angeordnet sind, wobei die aktive Zone ausgelegt ist, optische Pumpstrahlung der ersten Wellenlänge durch Mehrphotonenabsorption zu absorbieren und eine optische Strahlung einer zweiten Wellenlänge zu erzeugen, die kürzer als die erste Wellenlänge ist, wobei die aktive Zone eine Kavität aufweist, wobei die Kavität eine Resonanzfrequenz aufweist, die eine Resonanzüberhöhung der optischen Strahlung hervorruft, wobei das Halbleiterbauelement und die Pumplaserdiode derart zueinander positioniert sind, dass die optische Pumpstrahlung während des Betriebs der Pumplaserdiode über die Eintrittsfacette in das Halbleiterbauelement eintritt, und die optische Strahlung über die Austrittsfacette extrahiert wird, wobei die Eintrittsfacette eine Reflektivität für die Pumpstrahlung von kleiner als 0,1 und eine Reflektivität für die optische Strahlung von größer als 0,7 aufweist, und die Austrittsfacette eine Reflektivität für die optische Strahlung zwischen 0,01 und 0,2 und eine Reflektivität für die Pumpstrahlung von größer als 0,5 aufweist.

Vorzugsweise wird die Pumpstrahlung in der aktiven Zone ausschließlich durch Mehrphotonenabsorption absorbiert.

Optische Strahlung ist Teil des elektromagnetischen Spektrums und umfasst vorzugsweise ultraviolette Strahlung, das für Menschen sichtbare Licht sowie Infrarotstrahlung. Insbesondere umfasst optische Strahlung auch Laserstrahlung, d.h. im Allgemeinen kohärente optische Strahlung.

Das gemäß der Erfindung verwendete Halbleiterbauelement ermöglicht durch die Wellenleiterschicht eine Wellenführung parallel zum Substrat, d.h. eine Führung der optischen Pumpstrahlung als auch der optischen Strahlung der zweiten Wellenlänge. Die Wellenführung ist flexibel durch das epitaktische Aufwachsen der Halbleiterschichten einstellbar. Durch laterale Strukturierung der Halbleiterschichten oder durch Aufbringen weiterer lateral strukturierter Schichten kann laterale Wellenführung erreicht werden.

Epitaxie ist im Allgemeinen eine Form des Kristallwachstums, bei dem die Halbleiterschicht auf das vorzugsweise kristallin vorliegende Halbleitersubstrat aufgewachsen werden kann. Epitaxie bezeichnet dabei im Wesentlichen den Fall, dass eine kristallographische Orientierung der aufgewachsenen Halbleiterschicht einer Orientierung des kristallinen Halbleitersubstrats bzw. einer darunterliegenden Halbleiterschicht entspricht. Ein Vorteil epitaktisch hergestellter Halbleiterschichten liegt beispielsweise darin, dass durch Kombination von Schichten mit unterschiedlicher Zusammensetzung (Heterostrukturen) elektrooptische Eigenschaften erzielt werden, die mit herkömmlichen Kristallen nur einer Zusammensetzung nicht herstellbar sind. Epitaxie kann auch abruptere Übergänge von Dotierstoffkonzentrationen ermöglichen als beispielsweise durch herkömmliche Diffusions- oder Ionenimplantationsverfahren erreichbar wäre. Epitaxie erlaubt es auch, zur lateralen Wellenführung beispielsweise vergrabene Strukturen zu nutzen, die ein flexibleres Design der Bauelementstrukturen ermöglichen können.

Das gemäß der Erfindung verwendete Halbleiterbauelement ermöglicht durch Mehrphotonenabsorption auf vorteilhafte Weise eine Frequenzkonversion, ohne dabei die erste Wellenlänge bzw. die entsprechende erste Frequenz der optischen Pumpstrahlung mittels bekannter nichtlinearer Kristalle, wie Lithiumniobat $LiNbO_3$, Kaliumdihydrogenphosphat KDP, Beta-Bariumborat BBO, z.B. zur zweiten Harmonischen zu vervielfachen. Wird ein herkömmlicher Kristall mit hoher Intensität gepumpt, erzeugt er durch Nichtlinearitäten optische Strahlung bei Frequenzvielfachen der ersten Frequenz, wobei Leistungs- und Modenstabilität nur schwer erreichbar ist. Die bei höheren Leistungen auch eingesetzten bekannten Strukturen mit Quasi-Phasenanpassung weisen häufig große Parameterstreuungen auf, sodass die Bauteiltemperatur einer genauen und für das jeweilige Bauelement individuellen Regelung bedarf. Dieser Aufwand entfällt beim erfindungsgemäßen Halbleiterbauelement bei gleichzeitig besserer Leistungs- und Modenstabilität der erzeugten optischen Strahlung.

Die Mehrphotonenabsorption bezeichnet allgemein die simultane Absorption mehrerer Photonen durch ein Molekül oder ein Atom, das dabei in einen energetisch angeregten Zustand übergeht. Der Vorteil der Mehrphotonenabsorption liegt insbesondere in der Erzeugung kohärenter Strahlung mit einem reellen Vielfachen der ersten Frequenz der Pumpstrahlung. Dadurch kann das erfindungsgemäße Halbleiterbauelement die optische Pumpstrahlung mit der ersten Wellenlänge bzw. der entsprechenden ersten Frequenz in die optische Strahlung mit der zweiten Wellenlänge bzw. der entsprechenden zweiten Frequenz konvertieren, wobei die zweite Wellenlänge kürzer als die erste Wellenlänge ist bzw. die zweite Frequenz höher als die erste Frequenz ist. Das Halbleiterbauelement kann insbesondere optische Strahlung mit einer zweiten Wellenlänge von 630 nm bis 220 nm oder bis 210 nm erzeugen.

Vorzugsweise ist das gemäß der Erfindung verwendete Halbleiterbauelement als kantenemittierender Halbleiterlaser ausgebildet. Als kantenemittierendes Bauelement im Sinne der vorliegenden Erfindung wird ein Bauelement verstanden, das die Strahlung über eine lateral zu den Schichten angeordnete Kante der aktiven Schicht (bzw. der aktiven Zone) emittiert. Somit erfolgt die Emission (Auskopplung) der Strahlung nicht vertikal über die Oberseite bzw. Unterseite des Schichtsystems (also nicht durch die Wellenleiterschichten hindurch). Vorzugsweise weist das erfindungsgemäße Halbleiterbauelement eine jeweils lateral angeordnete Einkoppel-(nachfolgend auch als Eintrittsfacette bezeichnet) und Auskoppelfacette (nachfolgend auch als Austrittsfacette bezeichnet) auf, die in Kombination mit den Wellenleiterschichten geeignet sind, einerseits eine Wellenführung für die emittierte Laserstrahlung in der Ebene der Halbleiterschichtstruktur zu realisieren und andererseits einen longitudinalen (d.h. sich parallel zu den Schichten erstreckenden) Resonator für die Laserstrahlung auszubilden. Dies erlaubt vorteilhafterweise die (bevorzugte) Integration von Gitterstrukturen, wobei sich die Gitterstege entlang der Längsachse des Resonator, also zwischen Eintritts- und Austrittsfacette des Halbleiterbauelements erstrecken.

Vorzugsweise ist das gemäß der Erfindung verwendete Halbleiterbauelement derart ausgebildet, dass mittels der Wellenleiterschichten eine kollineare Führung von Pumpstrahlung und erzeugter Laserstrahlung realisiert wird, die einerseits eine effiziente Absorption der Pumpstrahlung auch bei geringen Absorptionskoeffizienten erlauben, wie sie unterhalb der Bandkante für Mehrphotonenprozesse typisch sind, und andererseits eine Erzeugung der Laserstrahlung bei der zweiten, kürzeren Wellenlänge über die gesamte Ausdehnung des Bauelements (der aktiven Schicht bzw. der aktiven Zone) erlauben. Somit ist es vorteilhafterweise möglich, für die aktive Schicht Materialien zu verwenden, die zwar einen verhältnismäßig geringen Absorptionskoeffizienten in Bezug auf die Pumpstrahlung haben, aber aufgrund der Erstreckung der Kavität über die (nahezu) gesamte Länge der Kavität und die hohe Reflektivität der die Kavität bildenden Elemente (Facetten, Gitter) in Bezug auf die Pumpstrahlung trotzdem eine effiziente Absorption der Pumpstrahlung realisieren. Es ist daher möglich, die aktive Zone derart auszubilden, dass der Absorptionskoeffizient kleiner als 100 cm$^{-1}$, bevorzugter kleiner als 10 cm$^{-1}$ ist.

Diese Laserstrahlung kann erfindungsgemäß über die Austrittsfacette extrahiert werden. Dabei ist es bevorzugt, dass zumindest die Austrittsfacette für die erzeugte Laserstrahlung (weitgehend) transparent ist. Dies ist bei gängigen Materialien für Beschichtungen für die angestrebten Emissionswellenlängen oft nicht bzw. nur sehr eingeschränkt mit der Forderung nach hoher Reflektivität bei der Pumpwellenlänge vereinbar. In einem solchen Fall ist es bevorzugt, durch die Integration mindestens eines Gitters die Reflektivität für die Pumpstrahlung (Pumpwellenlänge) und die Laserstrahlung (Emissionswellenlänge) weitgehend getrennt steuern zu können.

Die Eintrittsfacette wird durch Beschichtung mit einem dielektrischen Schichtpaket in Bezug auf die Laserstrahlung vorzugsweise mit einer höheren Reflektivität als die Austrittsfacette ausgebildet. Besonders bevorzugt werden die Beschichtungen der Eintrittsfacette und/oder die Austrittsfacette einschichtig ausgebildet. Dabei ist vorzugsweise die Absorption der Laserstrahlung in diesen Schichten vernachlässigbar.

Vorzugsweise weist die Eintrittsfacette eine Reflektivität für die Pumpstrahlung von kleiner als 0,05 und noch bevorzugter kleiner als 0,01 auf. Vorzugsweise weist die Eintrittsfacette eine Reflektivität für die Laserstrahlung von größer als 0,9 und noch bevorzugter größer als 0,95 auf.

Vorzugsweise weist die Austrittsfacette eine Reflektivität für die Laserstrahlung zwischen 0,02 und 0,15 und noch bevorzugter zwischen 0,03 und 0,1 auf. Vorzugsweise weist die Austrittsfacette eine Reflektivität für die Pumpstrahlung von größer als 0,7 und noch bevorzugter größer als 0,9 auf.

Vorzugsweise ist ein die Laserstrahlung reflektierendes Gitter im Bereich der Eintrittsfacette integriert. Dieses Gitter erstreckt sich vorzugsweise lediglich über 50%, bevorzugter lediglich über 30% und noch bevorzugter lediglich über 15% der Ausdehnung zwischen der Eintrittsfacette und der Austrittsfacette.

Vorzugsweise ist ein die Pumpstrahlung reflektierendes Gitter im Bereich der Austrittsfacette integriert. Dieses Gitter erstreckt sich vorzugsweise lediglich über 50%, bevorzugter lediglich über 30% und noch bevorzugter lediglich über 15% der Ausdehnung zwischen der Eintrittsfacette und der Austrittsfacette.

Die Eintrittsfacette und die Austrittsfacette sind bevorzugterweise lediglich an den lateralen (seitlichen) Bereichen des Halbleiterbauelements angeordnet. Die Eintrittsfacette und die Austrittsfacette liegen in Bezug auf die aktive Zone einander gegenüber. Die Eintrittsfacette und die Austrittsfacette kontaktieren die seitlichen Bereiche (Kanten) der aktiven Zone vorzugsweise direkt.

Vorzugsweise erstreckt sich die aktive Schicht (aktive Zone) vollständig zwischen der Eintrittsfacette und der Austrittsfacette. Vorzugsweise ist die aktive Schicht (aktive Zone) zwischen Eintrittsfacette und Austrittsfacette bezüglich ihrer Zusammensetzung und ihrer Schichtdicke uniform ausgebildet. Vorzugsweise ist die aktive Schicht (aktive Zone) streifenförmig ausgebildet. Vorzugsweise ist die aktive Schicht (aktive Zone) zwischen Eintrittsfacette und Austrittsfacette bezüglich ihrer Breite uniform ausgebildet.

Es ist weiterhin bevorzugt, dass das gemäß der Erfindung verwendete Halbleiterbauelement lediglich und ausschließlich optisch gepumpt wird. Daher ist es bevorzugt, dass die Wellenleiterschichten die aktive Zone über die gesamte Länge zwischen Eintrittsfacette und Austrittsfacette direkt kontaktieren, also keine (zusätzlichen) Elektroden zwischen der aktive Zone und den Wellenleiterschichten vorgesehen sind. Weiterhin ist es bevorzugt, dass die der Halbleitersubstratschicht nächstgelegene Wellenleiterschicht sowohl die Halbleitersubstratschicht als auch die aktive Zone über die gesamte Länge zwischen Eintrittsfacette und Austrittsfacette direkt kontaktiert, also keine (zusätzliche) Elektrode zwischen der Wellenleiterschicht und der Halbleitersubstratschicht vorgesehen ist. Es ist mithin bevorzugt, dass das erfindungsgemäße Halbleiterbauelement keinerlei Elektroden (oder sonstige Mittel) zur Injektion von Ladungsträgern in die aktive Schicht (aktive Zone) aufweist. Mithin ist bevorzugt, dass das erfindungsgemäße Halbleiterbauelement neben der aktiven Zone keinerlei weiteren (nichtlinearen) emittierenden optischen Schichten (die ggf. in einer anderen Wellenlänge als die aktiven Zone emittieren) zwischen den Wellenleiterschichten aufweist.

Bevorzugt kann die aktive Zone wenigstens einen Quantengraben umgeben von Barrieren und optional Spacerschichten zwischen Quantengraben und Barrieren umfassen, wobei die Barrieren und die Spacerschichten eine größere Bandlücke als der Quantengraben aufweisen. Vorzugsweise können die Barrieren und die Spacerschichten epitaktisch aufgewachsene Halbleiterschichten sein.

Ein Quantengraben, auch Quantentopf oder Quantenfilm genannt, bezeichnet im Wesentlichen einen Potentialverlauf, der die Bewegungsfreiheit eines Elektrons in einer Raumdimension einschränkt. Die Dicke des Quantengrabens bestimmt vorzugsweise die quantenmechanischen Zustände, die das Elektron einnehmen kann. Der Quantengraben ist vorzugsweise von einer Halbleiterheterostruktur umgeben, beispielsweise von Spacerschichten und/oder Barrieren.

Des weiteren kann der wenigstens eine Quantengraben vorteilhaft derart ausgelegt werden, dass er die halbe Wellenlänge oder ein Drittel der Wellenlänge oder ein Viertel der ersten Wellenlänge der Pumpstrahlung absorbieren kann.

Die optische Pumpstrahlung der ersten Wellenlänge bzw. die Photonen der Pumplaserdiode werden insbesondere im Quantengraben durch Mehrphotonenabsorption absorbiert, so kann optische Strahlung der zweiten Wellenlänge entstehen, die kürzer als die erste Wellenlänge ist. Die zweite Wellenlänge kann dabei allgemein als x-Vielfaches der ersten Wellenlänge beispielsweise mittels der Schichtdicke des Quantengrabens eingestellt werden, wobei x eine positive reelle Zahl größer gleich zwei ist. Herkömmliche Frequenzvervielfachungen mittels nichtlinearer Kristalle ermöglichen im Vergleich dazu nur ganzzahlige Frequenzvielfache.

In einer bevorzugten Weiterbildung kann die aktive Zone mehrere Quantengräben umfassen. Vorzugsweise ist eine Barriere zwischen zwei Quantengräben angeordnet, die die halbe Wellenlänge der ersten Wellenlänge der Pumpstrahlung absorbieren kann.

Vorzugsweise kann die aktive Zone wenigstens zwei Spacerschichten umfassen, zwischen denen die mehreren Quantengräben und die die Quantengräben umgebenden Barrieren angeordnet sind. Vorzugsweise sind die Quantengräben aus AlGaN oder AlGaIn ausgebildet. Vorzugsweise sind die Barrieren ebenfalls aus Al-GaN AlGaInN (mit einem höheren Al-Gehalt) ausgebildet.

Vorzugsweise weist die aktive Zone und/oder mindestens eine der Wellenleiterschichten ein halbleitendes Material mit einer Wurzit-Struktur auf. Bevorzugt kann die Wellenleiterschicht mehrere Schichten umfassen, die (Al, Ga, In)N aufweisen. (Al, Ga, In)N, wobei Al für Aluminium, Ga für Gallium, In für Indium und N für Stickstoff (bzw. in chemischen Verbindung als Nitride bezeichnet) steht, ist im Wesentlichen ein quaternärer Mischkristall. Dieser Mischkristall kann beispielsweise als Barriere oder als Wellenleiter für die erzeugte optische Strahlung im Bereich 630 nm bis 220 nm wirken. (Al, Ga, In)N gehört allgemein zu den III-V-Verbindungshalbleitern, die sich vorteilhaft beispielsweise für Wellenlängen im ultravioletten Bereich, d.h. z.B. für Wellenlängen kleiner als 380 nm eignen können.

In einer weiteren vorteilhaften Ausführung kann die Wellenleiterschicht mehrere Schichten umfassen, die (Be, Mg, Zn, Cd)O oder (Be, Mg, Zn, Cd)(Se, S) aufweisen, wobei Be für Beryllium, Mg für Magnesium, Zn für Zink, Cd für Cadmium, O für Sauerstoff, Se für Selen und S für Schwefel steht. Der (Be, Mg, Zn, Cd)O bzw. (Be, Mg, Zn, Cd)(Se, S) Mischkristall gehören allgemein zu den II-VI-Verbindungshalbleitern, die sich aufgrund ihrer großen Bandlücke insbesondere gut für Halbleiterlaseranwendungen im kürzerwelligen Spektralbereich, beispielsweise für optische Strahlung im Bereich 630 nm bis 220 nm eignen können. II-VI-Verbindungshalbleiter sind insbesondere durch epitaktisches Wachstum herstellbar.

Vorzugsweise kann die Wellenleiterschicht dazu ausgelegt sein, die optische Pumpstrahlung und die erzeugte optische Strahlung zu leiten.

Ferner ist es bevorzugt, dass gespaltene und beschichtete Facetten und/oder eine Gitterstruktur einen Resonator (Kavität) für die erzeugte optische Strahlung mit der zweiten Wellenlänge bilden können.

Insbesondere kann die aktive Zone eine Gitterstruktur aufweisen, die ausgelegt ist die zweite Wellenlänge der erzeugten optischen Strahlung zu reflektieren. Diese ist vorzugsweise in der Nähe der Eintrittsfacette angeordnet.

Vorzugsweise weist die aktive Zone eine Gitterstruktur auf, die ausgelegt ist die erste Wellenlänge der Pumpstrahlung zu reflektieren. Diese ist vorzugsweise in der Nähe der Austrittsfacette angeordnet.

Die aktive Zone weist eine Kavität auf, die von Facetten oder durch eine Gitterstruktur oder durch eine Kombination davon begrenzt ist. Die Facetten sind vorzugsweise gebrochen und beschichtet. Die Kavität weist eine Resonanzfrequenz auf, die eine Resonanzüberhöhung der Pumpstrahlung hervorrufen kann. Die Facetten bzw. die Gitterstruktur wirken beispielsweise als Spiegel für die Pumpstrahlung und können dazu beitragen, deren Photonen zu reflektieren. Insbesondere weisen die Facetten und/oder die eingebrachte Gitterstruktur eine Reflektivität auf, die für die im Quantengraben oder in den Quantengräben erzeugte optische Strahlung ausreicht, um Lasertätigkeit bei der Wellenlänge der erzeugten optischen Strahlung mit der zweiten Wellenlänge zu ermöglichen.

Die zweite Wellenlänge des Halbleiterbauelements umfasst vorzugsweise einen Bereich von 220 bis 630 nm. Die zweite Wellenlänge ist dabei insbesondere über die epitaktisch aufgewachsenen Halbleiterschichten einfach einstellbar.

Das erfindungsgemäße System ermöglicht eine kompakte Bauform für Halbleiterlaser zur Erzeugung von optischer Strahlung bzw. Laserstrahlung im Bereich 630 nm bis 220 nm. Besonders bevorzugt ist das Material der aktiven Zone des Halbleiterbauelements geeignet, optische Strahlung mit einer Wellenlänge von kleiner als 350 nm zu emittieren.

Vorzugsweise sind das gemäß der Erfindung verwendete Halbleiterbauelement und die Pumplaserdiode derart zueinander angeordnet, dass eine kollineare Führung von Pumpstrahlung und Laserstrahlung realisiert wird, die eine effiziente Absorption der Pumpstrahlung auch bei geringen Absorptionskoeffizienten, wie sie unterhalb der Bandkante für Mehrphotonenprozesse typisch sind und eine Erzeugung der Laserstrahlung bei der zweiten, kürzeren Wellenlänge über die gesamte Ausdehnung des Bauelements (also über die gesamte Ausdehnung der aktiven Zone zwischen den Facetten) erlaubt. Die Pumplaserdiode ist vorzugsweise als kantenemittierende Laserdiode ausgebildet. Vorzugsweise sind das erfindungsgemäße Halbleiterbauelement und die Pumplaserdiode räumlich eng beieinander angeordnet. Dabei kontaktiert die Pumplaserdiode die Eintrittsfacette des Halbleiterbauelements nicht direkt. Vielmehr ist es bevorzugt, eine Lücke zwischen 0,5 µm und 20 µm zwischen der Austrittsfacette der Pumplaserdiode und der Eintrittsfacette des Halbleiterbauelements vorzusehen. In einer weiteren vorteilhaften Ausführung wird die Strahlung der Pumplaserdiode über ein abbildende Optik, vorteilhafter Weise eine GRIN-Linse auf die Eintrittsfacette des Halbleiterbauelements abgebildet. Dies erhöht den Herstellungsaufwand aber gleichzeitig auch die Flexibilität beim Design des Systems.

Die erste Wellenlänge der Pumplaserdiode muss nicht mehr zwingend in einem geradzahligen Verhältnis zur erzeugten zweiten Wellenlänge stehen, wie dies etwa bei herkömmlicher Frequenzverdopplung der Fall ist. Stattdessen erlaubt das erfindungsgemäße System auf vorteilhafte Weise den Einsatz günstig herstellbarer und effizienter Pumplaserdioden anderer Wellenlängen, die beispielsweise in einem reellen Verhältnis größer gleich zwei zur erzeugten zweiten Wellenlänge stehen können.

Die Pumplaserdiode umfasst bevorzugt insbesondere das Halbleitermaterial GaAs und kann die optische Pumpstrahlung der ersten Wellenlänge zwischen 625 nm und 1300 nm erzeugen. GaAs steht dabei für Galliumarsenid.

In einer vorteilhaften Ausführung kann die Pumplaserdiode das Halbleitermaterial GaN umfassen und die optische Pumpstrahlung mit der ersten Wellenlänge zwischen 380 nm und 550 nm erzeugen. GaN steht dabei für Galliumnitrid.

In einer weiteren vorteilhaften Ausführung kann die Pumplaserdiode das Halbleitermaterial InP umfassen und die optische Pumpstrahlung mit der ersten Wellenlänge zwischen 1250 nm und 1800 nm erzeugen. InP steht dabei Indiumphosphid.

Das Halbleiterbauelement weist einen internen Resonator gebildet von den Facetten und/oder integrierten Gittern auf, so dass kein externer Resonator für den Laserbetrieb notwendig ist.

Bevorzugt kann das epitaktische Aufwachsen der aktiven Zone des Halbleiterbauelements folgende Schritte umfassen:

- Bilden einer erste Spacerschicht,
- Bilden des ersten Quantengrabens auf der ersten Spacerschicht,
- Bilden einer Barriere auf dem ersten Quantengraben,
- Bilden eines zweiten Quantengrabens auf der Barriere,
- Bilden einer zweiten Spacerschicht auf dem zweiten Quantengraben.

### *Kurzbeschreibung der Zeichnungen*

Ausführungsbeispiele der Erfindung werden anhand der Zeichnungen und der nachfolgenden Beschreibung näher erläutert. Es zeigen:

Figur 1     ein Diagramm eines elektromagnetischen Spektrums,

Figur 2     ein erfindungsgemäßes Halbleiterbauelement, und

Figur 3    ein erfindungsgemäßes System zur Frequenzkonversion.

### Ausführliche Beschreibung der Zeichnungen

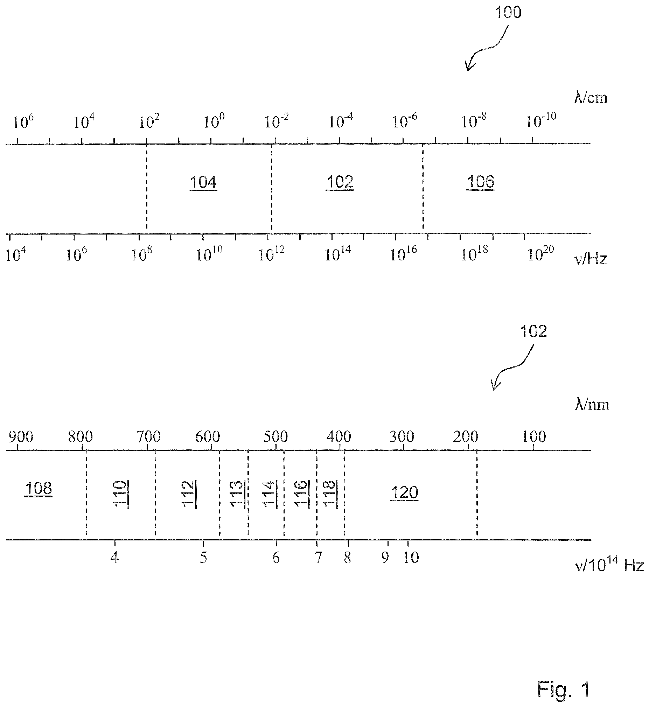

In der Figur 1 ist ein Diagramm mit einem elektromagnetischen Spektrum 100 gezeigt. Die obere Skala des Diagramms bezeichnet die Wellenlängen $\lambda$ in cm. Die untere Skala des Diagramms bezeichnet die entsprechende Frequenz $\nu$ in Hz. Ein vergrößerter Ausschnitt aus dem elektromagnetischen Spektrum 100 zeigt insbesondere einen Bereich 102 für optische Strahlung. Der Bereich 102 für optische Strahlung liegt zwischen dem Bereich 104 für Radar und Mikrowellen sowie dem Bereich 106 für Röntgenstrahlung. Der Bereich 102 für optische Strahlung weist eine obere Skala für die Wellenlängen $\lambda$ in nm und eine untere Skala für die entsprechende Frequenz $\nu$ in $10^{14}$ Hz auf. Der Bereich 102 unterteilt sich von langwellig zu kurzwellig wie folgt: ein Bereich 108 für Infrarotstrahlung, insbesondere nahe Infrarotstrahlung, ein Bereich 110 für rotes sichtbares Licht, ein Bereich 112 für oranges sichtbares Licht, ein Bereich 113 für gelbes sichtbares Licht, ein Bereich 114 für grünes sichtbares Licht, ein Bereich für 116 blaues sichtbares Licht, ein Bereich für 118 für violettes sichtbares Licht und ein Bereich 120 für nahe ultraviolette Strahlung.

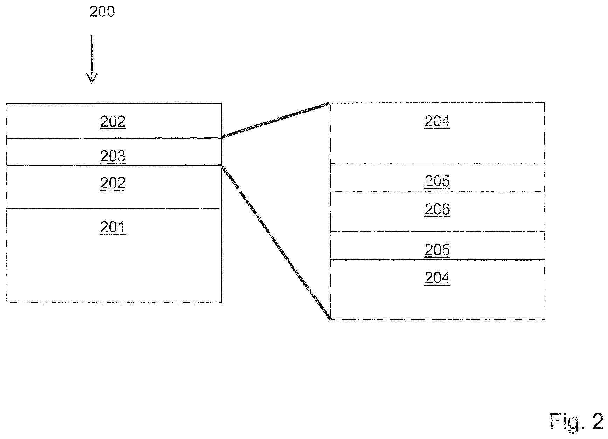

In der Figur 2 ist ein Halbleiterbauelement 200 schematisch gezeigt, das eine Halbleitersubstratschicht 201 aufweist, auf dem der Reihe nach mehrere Halbleiterschichten angeordnet sind, nämlich eine erste Wellenleiterschicht 202, eine aktive Zone 203 und eine zweite Wellenleiterschicht 202 epitaktisch aufgewachsen sind. Die aktive Zone 203 ist neben dem in der Figur gezeigten Halbleiterbauelement 200 vergrößert gezeigt. Die aktive Zone 203 umfasst eine erste Spacerschicht 204, auf der der Reihe nach ein erster Quantengraben 205, eine Barriere 206, ein zweiter Quantengraben 205 und eine zweite Spacerschicht 204 gebildet sind. Die erste und die zweite Wellenleiterschicht 202 führen der aktiven Zone 203 optische Pumpstrahlung mit einer ersten Wellenlänge von einer Halbleiterlaserdiode (nicht gezeigt) zu. Die Barriere 206 und die Spacerschichten 204 weisen eine größere Bandlücke als die Quantengräben 205 auf. Die Spacerschichten 204 besitzen dabei eine größere Bandlücke als die Barriere 206, aber eine kleinere Bandlücke als die jeweils angrenzende Wellenleiterschicht 202 auf. In einer solchen Anordnung gelingt es, die durch Mehrphotonenabsorption in den Quantengräben 205 und ggf. der Barriere 206 erzeugten Ladungsträger in den Quantengräben einzuschließen und für die stimulierte Emission bei der zweiten Wellenlänge verfügbar zu machen.

Die Quantengräben 205 sind in einer beispielhaften Ausführung aus $Al_xGa_{1-x}N$ mit einem Al-Gehalt von etwa x=0,1 und einer Dicke von 2 nm, und emittieren bei etwa 340 nm. Die Barriere 206 ist eine $Al_xGa_{1-x}N$ Struktur von 10 nm Dicke und einem Al-Gehalt von etwa x=0,13, die bei 330 nm absorbiert. Die Spacerschichten 204 weisen einen höheren Al-Gehalt von x=0,2 auf und sind oberhalb von 310 nm transparent. Die umgebenden Wellenleiterschichten 202 sind derart dimensioniert, dass Sie als Wellenleiter wirken und sowohl für die erzeugte zweite Strahlung von 340 nm als auch für die Pumpstrahlung mit einer Wellenlänge zwischen 660 nm und 640 nm eine Wellenführung gewährleisten. Wird diese Anordnung mit der Pumpstrahlung im Bereich von 660 nm bis 640 nm durch eine gespaltene Facetten gepumpt, so kann diese in der Barriere und den Quantengräben über Zweiphotonenabsorption absorbiert werden. Die erzeugten Elektron-Loch-Paare werden zwischen den Spacerschichten lokalisiert und können dann in den Quantengräben die zweite Strahlung mit einer Wellenlänge um 340 nm erzeugen. Bei geeigneter Rückkopplung kann diese Strahlung stimuliert als Laserstrahlung emittiert werden.

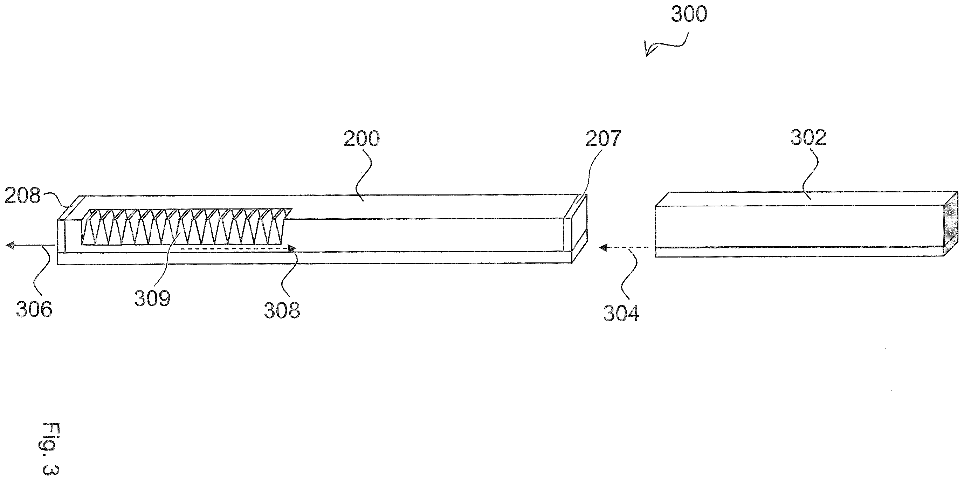

In der Figur 3 ist ein Ausführungsbeispiel eines erfindungsgemäßen Systems 300 zur Frequenzkonversion gezeigt. Das System 300 umfasst eine Halbleiterlaserdiode 302, die eine Pumpstrahlung 304 mit einer ersten Wellenlänge im Bereich zwischen 640 nm und 660 nm erzeugt.

Die Halbleiterlaserdiode 302 strahlt die Pumpstrahlung auf die Stirnfläche des Halbleiterbauelements 200 derart, dass sie im Wellenleiter geführt werden kann. In der Figur 3 ist ein senkrechtes Auftreffen dargestellt, es sind jedoch auch andere Winkel möglich.

Die Photonen der Pumpstrahlung 304 werden in den Quantengräben 205 durch Mehrphotonenprozesse absorbiert. Die Absorption erzeugt optische Strahlung 306 einer zweiten Wellenlänge von etwa 340 nm, die kürzer als die erste Wellenlänge ist.

In der aktiven Zone ist ferner eine Gitterstruktur 309 gebildet, die als Spiegel für die Pumpstrahlung 304 wirkt und eine reflektierte Pumpstrahlung 308 hervorruft. Dies verbessert die Umsetzung der Pumpstrahlung in optischen Strahlung 306 und vermindert die Emission von Pumpstrahlung 304 aus der Austrittsfacette 208. Bei geeigneter Auslegung des Gitters wirkt es gleichzeitig reflektierend für die optische Strahlung kürzerer Wellenlängen 306, so dass es zusammen mit der Eintrittsfacette 207 einen Resonator für diese Strahlung bildet. Zusätzlich kann die aktive Zone eine weitere (hier nicht dargestellte) Gitterstruktur aufweisen, die ausgelegt ist, die zweite Wellenlänge der erzeugten optischen Strahlung 306 zu reflektieren. Während die zur Reflexion der Pumpstrahlung 304 ausgelegte Gitterstruktur 309 bevorzugt im Bereich der Austrittsfacette 208 angeordnet ist, wird diese weitere Gitterstruktur vorzugsweise (von der Gitterstruktur 309 beabstandet) im Bereich der Eintrittsfacette 207 angeordnet.

Das Halbleiterbauelement 200 wirkt also als Frequenzkonverter und erzeugt optische Strahlung 306 der zweiten Wellenlänge, die grundsätzlich in den Bereichen 112, 113, 114, 116, 118 und 120 also von optisch sichtbarem orangen Licht bis in den nahen ultravioletten Bereich, d.h. von 630 nm bis 210 nm, liegen kann.

### Bezugszeichenliste

| | |
|---|---|
| 100 | elektromagnetisches Spektrum |
| 102 | Bereich für optische Strahlung |
| 104 | Bereich für Radar und Mikrowellen |
| 106 | Bereich für Röntgenstrahlung |
| 108 | Bereich für Infrarotstrahlung |
| 110 | Bereich für rotes sichtbares Licht |
| 112 | Bereich für oranges sichtbares Licht |
| 113 | Bereich für gelbes sichtbares Licht |
| 114 | Bereich für grünes sichtbares Licht |
| 116 | Bereich für blaues sichtbares Licht |
| 118 | Bereich für violettes sichtbares Licht |
| 120 | Bereich für nahe ultraviolette Strahlung |
| | |
| 200 | Halbleiterbauelement |
| 201 | Halbleitersubstrat |
| 202 | Wellenleiterschicht |
| 203 | aktive Zone |
| 204 | Spacerschicht |
| 205 | Quantengraben |
| 206 | Barriere |
| 207 | Eintrittsfacette |
| 208 | Austrittsfacette |
| | |
| 300 | System zur Frequenzkonversion |
| 302 | Halbleiterlaserdiode |
| 304 | Pumpstrahlung |
| 306 | optische Strahlung der zweiten Wellenlänge |
| 308 | reflektierte Pumpstrahlung |
| 309 | Gitterstruktur zur Reflexion der Pumpstrahlung |

### Patentansprüche

1. System (300) zur Frequenzkonversion mit

   a) einem kantenemittierenden Halbleiterbauelement (200) und
   b) einer davon beabstandeten Pumplaserdiode (302), die optische Pumpstrahlung (304) einer ersten Wellenlänge erzeugt,
   c) wobei das kantenemittierende Halbleiterbauelement (200) eine Halbleitersubstratschicht (201) und auf der Halbleitersubstratschicht (201) epitaktisch aufgewachsene Halbleiterschichten (202, 203, 204, 205, 206), die eine aktive Zone (203) und eine Wellenleiterschicht (202) umfassen, aufweist,
   d) wobei eine Eintrittsfacette (207) und eine Austrittsfacette (208) seitlich der aktiven Zone (203) angeordnet sind,
   e) wobei die aktive Zone (203) ausgelegt ist, optische Pumpstrahlung (304) der ersten Wellenlänge durch Mehrphotonenabsorption zu absorbieren und eine optische Strahlung (306) einer zweiten Wellenlänge zu erzeugen, die kürzer als die erste Wellenlänge ist,
   f) wobei die aktive Zone (203) eine Kavität aufweist, wobei die Kavität eine Resonanzfrequenz aufweist, die eine Resonanzüberhöhung der optischen Strahlung (306) hervorruft,
   g) wobei das Halbleiterbauelement (200) und die Pumplaserdiode (302) derart zueinander positioniert sind, dass die optische Pumpstrahlung (304) während des Betriebs der Pumplaserdiode (302) über die Eintrittsfacette (207) in das Halbleiterbauelement (200) eintritt, **dadurch gekennzeichnet, dass**
   h) die optische Strahlung (306) über die Austrittsfacette (208) extrahiert wird,
   i) wobei die Eintrittsfacette (207) eine Reflektivität für die Pumpstrahlung (304) von kleiner als 0,1 und eine Reflektivität für die optische Strahlung (306) von größer als 0,7 aufweist, und
   j) die Austrittsfacette (208) eine Reflektivität für die optische Strahlung (306) zwischen 0,01 und 0,2 und eine Reflektivität für die Pumpstrahlung (304) von größer als 0,5 aufweist.

2. System (300) zur Frequenzkonversion nach Anspruch 1, bei welchem die aktive Zone (203) wenigstens einen Quantengraben (205) umgeben von Barrieren (206) umfassen, wobei die Barrieren (206) eine größere Bandlücke als der Quantengraben (205) aufweisen.

3. System (300) zur Frequenzkonversion nach Anspruch 2, bei welchem der wenigstens eine Quantengraben (205) derart ausgelegt ist, dass er die halbe Wellenlänge oder ein Drittel der Wellenlänge oder ein Viertel der Wellenlänge der ersten Wellenlänge der Pumpstrahlung (304) absorbiert.

4. System (300) zur Frequenzkonversion nach Anspruch 2, bei welchem die aktive Zone (203) wenigstens zwei Spacerschichten (204) umfasst, zwischen denen die mehreren Quantengräben (205) und die die Quantengräben umgebenden Barrieren (206) angeordnet sind.

5. System (300) zur Frequenzkonversion nach einem der vorhergehenden Ansprüche, bei welchem die Wellenleiterschicht (202) mehrere Schichten umfasst, die (Al, Ga, In)N, (Be, Mg, Zn, Cd)O oder (Be, Mg, Zn, Cd)(Se, S) aufweisen.

6. System (300) zur Frequenzkonversion nach einem der vorhergehenden Ansprüche, bei welchem die aktive Zone (203) eine erste Gitterstruktur aufweist, die im Bereich der Eintrittsfacette (207) integriert und ausgelegt ist, die zweite Wellenlänge der erzeugten optischen Strahlung (306) zu reflektieren.

7. System (300) zur Frequenzkonversion nach einem der vorhergehenden Ansprüche, bei welchem die aktive Zone (203) eine zweite Gitterstruktur (309) aufweist, die im Bereich der Austrittsfacette (208) integriert und ausgelegt ist, die erste Wellenlänge der Pumpstrahlung (304) zu reflektieren.

8. System (300) zur Frequenzkonversion nach Anspruch 7, wobei die erste Gitterstruktur und die zweite Gitterstruktur (309) innerhalb der Kavität angeordnet und räumlich voneinander beabstandet sind.

9. System (300) zur Frequenzkonversion nach einem der vorhergehenden Ansprüche, wobei die Kavität mindestens von einer der Eintrittsfacette (207) und der Austrittsfacette (208) oder durch mindestens eine Gitterstruktur (309) oder durch eine Kombination davon begrenzt ist.

10. System (300) zur Frequenzkonversion nach Anspruch 9, wobei die Facetten (207, 208) gebrochen und beschichtet sind.

11. System (300) zur Frequenzkonversion nach einem der vorhergehenden Ansprüche, bei welchem die zweite Wellenlänge einen Bereich von 210 nm bis 630 nm umfasst.

12. System (300) nach einem der vorhergehenden Ansprüche , wobei die Pumplaserdiode (302) als kantenemittierendes Bauelement ausgebildet ist.

13. System (300) einem der vorhergehenden Ansprüche, bei welchem die Pumplaserdiode (302) das Halbleitermaterial GaAs umfasst und die optische Pumpstrahlung (304) mit der ersten Wellenlänge zwischen 625 nm und 1300 nm erzeugt, oder die Pumplaserdiode das Halbleitermaterial GaN umfasst und die optische Pumpstrahlung (304) mit der ersten Wellenlänge zwischen 380 nm und 550 nm erzeugt, oder die Pumplaserdiode (302) das Halbleitermaterial InP umfasst und die optische Pumpstrahlung (304) mit der ersten Wellenlänge zwischen 1250 nm und 1800 nm erzeugt.

**Claims**

1. A system (300) for frequency conversion with

    a) an edge-emitting semiconductor component (200) and
    b) a pump laser diode (302) at a distance from it, which generates the optical pump radiation (304) of a first wavelength,
    c) wherein the edge-emitting semiconductor component (200) features a semiconductor substrate layer (201) and on the semiconductor substrate layer (201), epitaxially grown semiconductor layers (202, 203, 204, 205, 206), which comprise an active zone (203) and a waveguide layer (202),
    d) wherein an entrance facet (207) and an exit facet (208) are arranged at the side of the active zone (203),
    e) wherein the active zone (203) is designed to absorb the optical pump radiation (304) of the first wavelength through multiple photon absorption and to generate an optical emission (306) of a second wavelength, which is shorter than the first wavelength,
    f) wherein the active zone (203) features a cavity, wherein the cavity features a resonance frequency which causes a resonance peak in the optical radiation (306),
    g) wherein the semiconductor component (200) and the pump laser diode (302) are positioned in relation to each other in such a manner that the optical pump radiation (304) enters the semiconductor element (200) via the entrance facet (207) during operation of the pump laser diode (302), **characterized in that**
    h) the optical radiation (306) is extracted via the exit facet (208),
    i) wherein the entrance facet (207) features a reflectivity for the pump radiation (304) of less than 0.1 and a reflectivity for the optical radiation (306) of greater than 0.7, and
    j) the exit facet (208) features a reflectivity for the optical radiation (306) of between 0.01 and 0.2 and a reflectivity for the pump radiation (304) of greater than 0.5.

2. The system (300) for frequency conversion according to claim 1, in which the active zone (203) comprises at least one quantum well (205) surrounded by barriers (206), wherein the barriers (206) feature a greater band gap than the quantum well (205).

3. A system (300) for frequency conversion according to claim 2, in which the at least one quantum well (205) is designed in such a manner that it absorbs half the wavelength or one-third of the wavelength, or one-quarter of the wavelength of the first wavelength of the pump radiation (304).

4. The system (300) for frequency conversion according to claim 2, in which the active zone (203) comprises at least two spacer layers (204), between which the multiple quantum wells (205) and the barriers (206) surrounding the quantum wells are arranged.

**5.** The system (300) for frequency conversion according to any one of the preceding claims, in which the waveguide layer (202) comprises multiple layers, which feature (Al, Ga, In)N, (Be, Mg, Zn, Cd)O or (Be, Mg, Zn, Cd)(Se, S).

**6.** The system (300) for frequency conversion according to any one of the preceding claims, in which the active zone (203) features a first grid structure, which is integrated in the area of the entrance facet (207) and designed to reflect the second wavelength of the generated optical radiation (306).

**7.** The system (300) for frequency conversion according to any one of the preceding claims, in which the active zone (203) features a second grid structure (309), which is integrated in the area of the exit facet (208) and designed to reflect the first wavelength of the pump radiation (304).

**8.** The system (300) for frequency conversion according to claim 7, wherein the first grid structure and the second grid structure (309) are arranged within the cavity and are spatially separate from each other.

**9.** The system (300) for frequency conversion according to any one of the preceding claims, wherein the cavity is bordered at least by one of the entrance facets (207) and the exit facet (208), or by at least one grid structure (309) or by a combination of these.

**10.** The system (300) for frequency conversion according to claim 9, wherein the facets (207, 208) are broken and coated.

**11.** The system (300) for frequency conversion according to any one of the preceding claims, in which the second wavelength comprises a range of 210 nm to 630 nm.

**12.** The system (300) according to any one of the preceding claims, wherein the pump laser diode (302) is designed as an edge-emitting component.

**13.** The system (300) according to any one of the preceding claims, in which the pump laser diode (302) comprises the semiconductor material GaAs and generates the optical pump radiation (304) with the first wavelength between 625 nm and 1300 nm, or the pump laser diode comprises the semiconductor material GaN and generates the optical pump radiation (304) with the first wavelength between 380 nm and 550 nm, or the pump laser diode (302) comprises the semiconductor material InP and generates the optical pump radiation (304) with the first wavelength between 1250 nm and 1800 nm.

**Revendications**

**1.** Système (300) de conversion de fréquence, avec

a) un composant semi-conducteur à émission latérale (200), et
b) une diode laser de pompage (302) espacée de celui-ci, laquelle génère un rayonnement de pompage optique (304) d'une première longueur d'onde,
c) où le composant semi-conducteur à émission latérale (200) comporte une couche de substrat semi-conducteur (201) et, sur ladite couche de substrat semi-conducteur (201), des couches de semi-conducteur (202, 203, 204, 205, 206) à croissance épitaxiale, lesquelles comprennent une zone active (203) et une couche de guide d'ondes (202),
d) où une facette d'entrée (207) et une facette de sortie (208) sont disposées latéralement à la zone active (203),
e) où la zone active (203) est prévue pour absorber le rayonnement de pompage optique (304) de la première longueur d'onde par absorption multiphotonique et générer un rayonnement optique (306) d'une deuxième longueur d'onde, plus courte que la première longueur d'onde,
f) où la zone active (203) présente une cavité, où la cavité présente une fréquence de résonance entraînant une surélévation de résonance du rayonnement optique (306),
g) où le composant semi-conducteur (200) et la diode laser de pompage (302) sont positionnés l'un par rapport à l'autre de telle manière que le rayonnement de pompage optique (304) pénètre par la facette d'entrée (207) dans le composant semi-conducteur (200) pendant le fonctionnement de la diode laser de pompage (302),
**caractérisé en ce que**
h) le rayonnement optique (306) est extrait par la facette de sortie (208),
i) la facette d'entrée (207) présentant une réflectivité inférieure à 0,1 pour le rayonnement de pompage (304), et une réflectivité supérieure à 0,7 pour le rayonnement optique (306), et
j) la facette de sortie (208) présentant une réflectivité comprise entre 0,01 et 0,2 pour le rayonnement optique (306) et une réflectivité supérieure à 0,5 pour le rayonnement de pompage (304).

**2.** Système (300) de conversion de fréquence selon la revendication 1, où la zone active (203) comprend au moins un puits quantique (205) entouré de barrières (206), lesdites barrières (206) présentant une bande interdite supérieure à celle du puits quantique (205).

3. Système (300) de conversion de fréquence selon la revendication 2, où ledit au moins un puits quantique (205) est prévu de manière à absorber une demi-longueur d'onde ou un tiers de longueur d'onde ou un quart de longueur d'onde de la première longueur d'onde du rayonnement de pompage (304).

4. Système (300) de conversion de fréquence selon la revendication 2, où la zone active (203) comprend au moins deux couches d'espacement (204), entre lesquelles sont disposés la pluralité de puits quantiques (205) et les barrières (206) entourant les puits quantiques.

5. Système (300) de conversion de fréquence selon l'une quelconque des revendications précédentes, où la couche de guide d'ondes (202) comprend plusieurs couches contenant (Al, Ga, In)N, (Be, Mg, Zn, Cd)O ou (Be, Mg, Zn, Cd)(Se, S).

6. Système (300) de conversion de fréquence selon l'une quelconque des revendications précédentes, où la zone active (203) présente une première structure de grille intégrée au niveau de la facette d'entrée (207) et prévue pour réfléchir la deuxième longueur d'onde du rayonnement optique (306) généré.

7. Système (300) de conversion de fréquence selon l'une quelconque des revendications précédentes, où la zone active (203) présente une deuxième structure de grille (309) intégrée au niveau de la facette de sortie (208) et prévue pour réfléchir la première longueur d'onde du rayonnement de pompage (304).

8. Système (300) de conversion de fréquence selon la revendication 7, où la première structure de grille et la deuxième structure de grille (309) sont disposées à l'intérieur de la cavité et sont spatialement espacées l'une de l'autre.

9. Système (300) de conversion de fréquence selon l'une quelconque des revendications précédentes, où la cavité est délimitée par la facette d'entrée (207) et/ou la facette de sortie (208) ou par au moins une structure de grille (309) ou par une combinaison de celles-ci.

10. Système (300) de conversion de fréquence selon la revendication 9, où les facettes (207, 208) sont brisées et revêtues.

11. Système (300) de conversion de fréquence selon l'une quelconque des revendications précédentes, où la deuxième longueur d'onde comprend une plage de 210 nm à 630 nm.

12. Système (300) selon l'une des revendications précédentes, où la diode laser de pompage (302) est réalisée comme composant à émission latérale.

13. Système (300) selon l'une des revendications précédentes, où la diode laser de pompage (302) comprend le matériau semi-conducteur GaAs et génère le rayonnement de pompage optique (304) à la première longueur d'onde entre 625 nm et 1300 nm, ou la diode laser de pompage comprend le matériau semi-conducteur GaN et génère le rayonnement de pompage optique (304) à la première longueur d'onde entre 380 nm et 550 nm, ou la diode laser de pompage (302) comprend le matériau semi-conducteur InP et génère le rayonnement de pompage optique (304) à la première longueur d'onde entre 1250 nm et 1800 nm.

Fig. 1

200

| 202 |
|---|
| 203 |
| 202 |
| 201 |

| 204 |
|---|
| 205 |
| 206 |
| 205 |
| 204 |

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20040061074 A
- DE 10312742 A1
- US 20040066823 A1
- US 5341390 A

**In der Beschreibung aufgeführte Nicht-Patentliteratur**

- **H.K. TSANG et al.** First demonstration oft wo photon absorption in a semiconductor waveguide pumped by a diode laser. *Electronics Letters,* vol. 29 (18), 1660